# EUROPÄISCHE PATENTSCHRIFT

(11) **EP 1 413 183 B1**
(45) Veröffentlichungstag und Bekanntmachung des Hinweises auf die Patenterteilung: **19.05.2010**
(21) Anmeldenummer: 02767275.7
(22) Anmeldetag: 30.07.2002
(51) Int. Cl.: H05K 13/00

(54) **POSITIONIEREINRICHTUNG FÜR GEGENSTÄNDE, INSBESONDERE FÜR PNEUMATISCHE HANDABUNGSVORRICHTUNGEN**
POSITIONING DEVICE FOR OBJECTS, ESPECIALLY FOR PNEUMATIC MANIPULATOR DEVICES
MECANISME DE POSITIONNEMENT D'OBJETS, CONCU EN PARTICULIER POUR DES DISPOSITIFS DE MANIPULATION PNEUMATIQUES

(30) Priorität: 31.07.2001 DE 20112634 U
(43) Veröffentlichungstag der Anmeldung: 28.04.2004
(73) Patentinhaber: FESTO AG & Co. KG, 73734 Esslingen (DE)
(72) Erfinder: STÖHR, Eberhard, 73732 Esslingen (DE); LÖBELENZ, Peter, 73660 Urbach (DE)
(74) Vertreter: Vetter, Hans
(86) Internationale Anmeldenummer: PCT/EP2002/008458
(87) Internationale Veröffentlichungsnummer: WO 2003/013209

(56) Entgegenhaltungen:
- WO-A-00/08905
- JP-A- 05 226 883
- JP-A- 09 051 195

## Beschreibung

Die Erfindung betrifft eine Positioniereinrichtung für Gegenstände, insbesondere für pneumatische Handhabungsvorrichtungen, mit Positioniermitteln zur Positionierung in wenigstens einer Raumrichtung, wobei die Positioniermittel an einer Haltevorrichtung für den zu positionierenden Gegenstand angreifen, der über eine pneumatische Stellgliedanordnung mit der Haltevorrichtung verbunden ist, wobei die Stellrichtung der Stellgliedanordnung der oder einer der Bewegungsrichtungen der Positioniermittel entspricht.

Eine solche Positioniereinrichtung ist aus JP 5226883 A bekannt.

Beispielsweise bei der Leiterplattenfertigung müssen Leiterplatten für die verschiedenen Arbeitsgänge positioniert, umgesetzt und zur nächsten Bearbeitungsstation weitergeführt werden. Die Positionierung und Bewegung der Leiterplatten erfolgt dabei üblicherweise mit einer Handhabungsvorrichtung, bei der eine Vielzahl von Sauggreifern in einer Ebene angeordnet ist. Auch andere Gegenstände müssen in ähnlicher Weise beispielsweise bei der Fertigung oder Montage positioniert werden, häufig durch pneumatische Anordnungen mit Stellgliedern und/oder Schlitten zur Positionierung in den drei Raumrichtungen, wobei auch Schwenk- und Rotationsvorgänge realisierbar sind. Bei der Positionierung in einer bestimmten Stellrichtung ist es häufig ein Problem, dass einerseits relativ große Stellwege im Dezimeterbereich durchgeführt werden sollen, andererseits eine Positioniergenauigkeit im mm- oder 1/10 mm-Bereich gefordert wird. Die bekannten technischen Lösungen hierzu erfordern einen sehr großen technischen und finanziellen Aufwand.

Eine Aufgabe der vorliegenden Erfindung besteht darin, eine Positioniereinrichtung zu schaffen, die auf kostengünstige Weise auch bei größeren Stellwegen eine sehr präzise Positionierung ermöglicht.

Diese Aufgabe wird erfindungsgemäß dadurch gelöst, dass die Stellgliedanordnung zur Feinpositionierung aus wenigstens einem Kontraktionsglied besteht, das über einen sich zwischen zwei Kopfstücken erstreckenden und bei Innendruckbeaufschlagung eine Längenkontraktion erfahrenden Kontraktionsschlauch verfügt.

Die Ausbildung einer Stellgliedanordnung mit einem oder mehreren Kontraktionsgliedern, wie sie beispielsweise aus dem von der Anmelderin herausgegebenen Prospekt "Fluidic Muscle" oder in der EP 0 161 750 B1 oder in der DE 299 06 626 U beschrieben sind, hat den Vorteil, dass eine sehr präzise Positionierung des zu positionierenden Gegenstands im mm- oder 1/10 mm-Bereich bei relativ geringen Kosten möglich ist. Ein einfacher und verschleißarmer Aufbau sind als weitere Vorteile zu nennen. Die Grobpositionierung kann dabei durch die herkömmlichen Positioniermittel erfolgen, und die Feinpositionierung erfolgt dann durch die Kontraktionsglieder aufweisende Stellgliedanordnung. Insbesondere großflächige Gegenstände, wie Platten, können dabei ohne die Gefahr eines Verkantens präzise positioniert werden. Mehrere Kontraktionsglieder, die jeweils mit demselben Innendruck beaufschlagt sind, erfahren dieselbe Längenkontraktion bzw. -ausdehnung, so dass beispielsweise bei zu positionierenden Platten eine exakte Bewegung senkrecht zur Plattenebene durchführbar ist.

Durch die in den Unteransprüchen aufgeführten Maßnahmen sind vorteilhafte Weiterbildungen und Verbesserungen der im Anspruch 1 angegebenen Positioniereinrichtung möglich.

Eine besonders präzise Feinpositionierung kann mit Kontraktionsgliedern erzielt werden, an deren beiden Kopfstücken eine zum Kontraktionsschlauch koaxiale Strangstruktur fixiert ist, die zwei in Überkreuzfiguration angeordnete Stranggruppen mit innerhalb einer jeweiligen Stranggruppe mit gleicher Längsorientierung nebeneinander verlaufenden biegeflexiblen Strängen besitzt. Die Präzision kann noch dadurch erhöht werden, dass die Stranggruppen durch ein dazwischenliegendes nachgiebiges Material, beispielsweise ein Gummimaterial oder ein Elastomermaterial, auf Abstand zueinander gehalten werden.

Die Positioniermittel sind zweckmäßigerweise zur Positionierung in den drei Raumrichtungen ausgebildet, wobei zusätzlich Einrichtungen zum Verschwenken und/oder Rotieren vorgesehen sein können, um eine variable Vorpositionierung zu bewerkstelligen. Die Positioniermittel sind dabei vorzugsweise pneumatisch betätigbar, jedoch sind auch andere Ausführungen denkbar, zum Beispiel hydraulische oder elektrische Lösungen.

Eine besonders präzise Positionierung des oder der Kontraktionsglieder wird durch ein damit verbundenes, den Innendruck gemäß einem vorgegebenen Sollwert einstellendes Proportional-Druckregelventil erreicht. Durch ein elektrisches Sollwert-Vorgabemodul können beliebige analoge Sollwerte beispielsweise über ein jeweils darin integriertes Potentiometer eingestellt werden. Eine digitale Sollwertvorgabe ist selbstverständlich ebenfalls möglich.

Besonders vorteilhaft kann eine solche Positioniereinrichtung für pneumatische Handhabungsvorrichtungen eingesetzt werden, insbesondere zur Handhabung von Platten und Folien. Die pneumatische Handhabungsvorrichtung kann dabei eine Vielzahl von in einer Ebene angeordneten Sauggreifern und/oder eine aus einem porösen Material oder Sintermaterial bestehende, mit einem Saugdruck beaufschlagbare Saugplatte besitzen, je nachdem, ob dickere und steifere oder dünnere und flexiblere Platten oder Folien handzuhaben sind. Zur Positionierung und Handhabung derartiger dünner Platten oder Folien unterhalb einer Dicke von beispielsweise 0,5 mm wird eine derartige Saugplatte verwendet, die über ihre gesamte Ansaugfläche einen gleichmäßigen geringen Ansaugdruck erzeugt, so dass sich diese Platten oder Folien an diese Ansaugfläche pneumatisch anlegen und dabei nicht verformt werden. Dickere und steifere Platten können dagegen mit Hilfe solcher Saugplatten nicht bewegt werden, da diese fertigungsbedingt üblicherweise nicht exakt eben sind und dadurch nicht vollflächig anliegen können. Für derartige Platten werden Sauggreifer-Anordnungen eingesetzt.

In vorteilhafter Weise kann die Saugplatte mit den Durchgriff der Sauggreifer gestattenden Durchbrüchen versehen sein, wobei in einer ersten Positionierstellung der Stellgliedanordnung die Sauggreifer über die Ansaugfläche der Saugplatte vorstehen und in einer zweiten Positionierstellung die Sauggreifer in die Durchbrüche hinein zurückversetzt sind, derart, dass sie nicht mehr über die Ansaugfläche der Saugplatte vorstehen. Durch einfache Betätigung der Kontraktionsglieder kann zwischen den beiden Positionierstellungen umgeschaltet werden, so dass eine Umstellung zwischen der Handhabung von dickeren und steiferen Platten einerseits und dünneren und flexibleren Platten andererseits schnell und ohne Rüstzeiten programmgesteuert erfolgen kann.

Zweckmäßigerweise sind Steuermittel zur Beaufschlagung der Saugplatte einerseits und der Sauggreifer andererseits mit Saugdruck vorgesehen, wobei die Sauggreifer nur in der ersten Positionierstellung mit Saugdruck beaufschlagbar sind. Hierdurch wird verhindert, dass die Sauggreifer in der zweiten Positionierstellung trotz gewissem Abstand von der zu handhabenden dünnen Folie oder Platte diese noch in die Durchbrüche hineinziehen und möglicherweise beschädigen können. Dabei kann in dieser ersten Positionierstellung zweckmäßigerweise der Saugdruck für die Saugplatte abgeschaltet werden, um einen unnötigen Verbrauch zu verhindern. Weiterhin kann Saugdruck dadurch eingespart werden, dass bei kleineren zu handhabenden Platten nur diejenigen Sauggreifer bzw. nur diejenigen Bereiche der Saugplatte mit Saugdruck beaufschlagt werden, die der Gestalt der Platte im Wesentlichen entsprechen.

In einer vorteilhaften konstruktiven Ausgestaltung ist die Saugplatte mit ihrer von der Ansaugfläche abgewandten Seite mit einer Saugdruck-Zuführungsplatte dichtend verbunden, die mit wenigstens einem Saugdruck-Zuführungsanschluss versehen ist, wobei dieser wenigstens eine Saugdruck-Zuführungsanschluss mit wenigstens einem flächigen Hohlraum zwischen den Platten verbunden ist, der durch eine Einformung an wenigstens einer der Platten gebildet ist. Durch den oder die flächigen Hohlräume wird erreicht, dass eine möglichst große Oberfläche der Saugplatte dem Saugdruck ausgesetzt ist, was wiederum dazu führt, dass die Saugdruckbeaufschlagung an der Ansaugfläche möglichst gleichmäßig ist. Die Saugdruck-Zuführungsplatte ist dabei zweckmäßigerweise mit den der Saugdruckplatte entsprechenden Durchbrüchen für die Sauggreifer versehen.

Ein Ausführungsbeispiel der Erfindung ist in der Zeichnung dargestellt und in der nachfolgenden Beschreibung näher erläutert. Es zeigen:
- Fig. 1: eine Vertikalschnittdarstellung einer Positionierungseinrichtung als Ausführungsbeispiel der Erfindung,

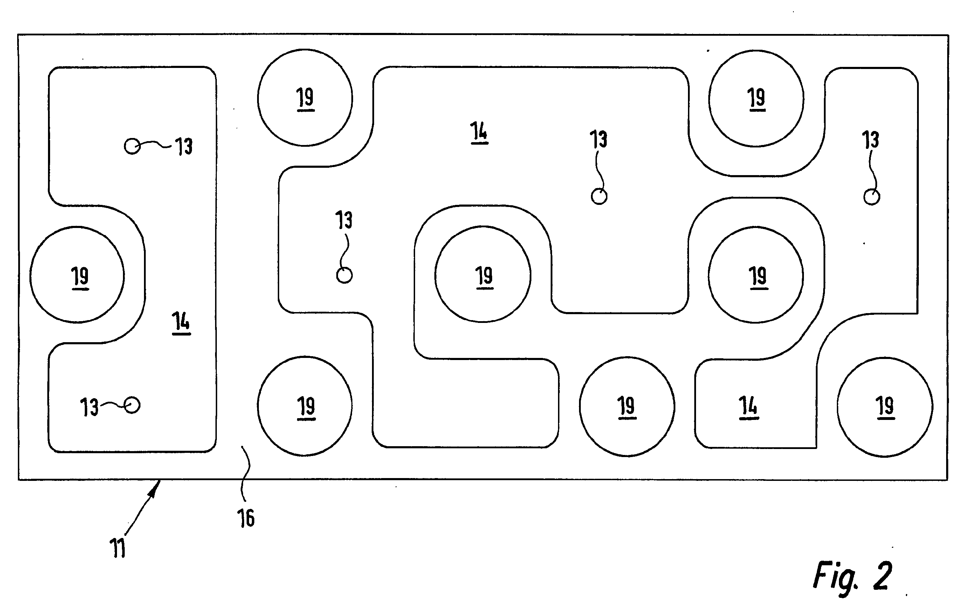

- Fig. 2: eine Ansicht der mit Einformungen versehenen Flachseite eine Saugdruck-Zuführungsplatte, die mit einer Saugplatte verbunden wird, und
- Fig. 3: eine Druckregelanordnung für die aus vier Kontraktionsgliedern bestehenden Positioniermittel.

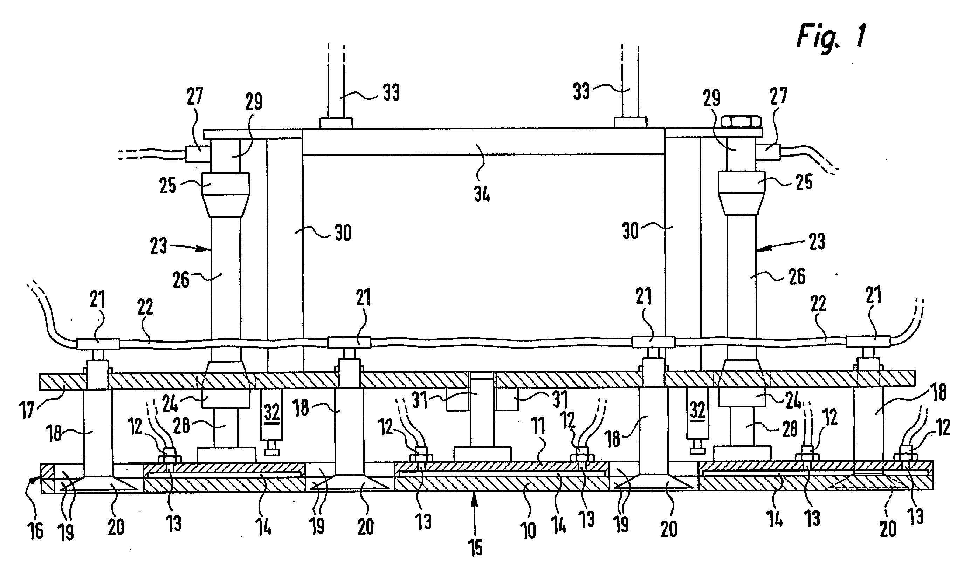

Die in Fig. 1 als Ausführungsbeispiel dargestellte Positionierungseinrichtung weist als zu positionierenden Gegenstand eine Verbundplatte auf, die aus einer aus einem porösen, luftdurchlässigen Material oder luftdurchlässigem Sintermaterial bestehenden Saugplatte 10 und einer damit verbundenen Saugdruck-Zuführungsplatte 11 besteht. Die Saugplatte 10 besteht dabei beispielsweise aus luftdurchlässigem Aluminium, wie es unter der Bezeichnung Metapor im Handel erhältlich ist. Andere metallische Sinterplatten können selbstverständlich ebenfalls eingesetzt werden. Auch die Saugdruck-Zuführungsplatte 11 besteht beispielsweise aus Aluminium, einer Aluminiumlegierung oder einem sonstigen Leichtmetall oder Metall.

Die von der Saugplatte 10 abgewandte Flachseite der Saugdruck-Zuführungsplatte 11 ist mit pneumatischen Anschlüssen 12 versehen, die über Kanäle 13 mit flächigen Einformungen 14 an der gegenüberliegenden Flachseite dieser Saugdruck-Zuführungsplatte 11 verbunden sind. Beim Verbinden der beiden Platten 10, 11 bilden diese Einformungen 14 flächige Hohlräume, durch die der an die Anschlüsse 12 angelegte Saugdruck eine möglichst große Fläche der Saugplatte 10 beaufschlagen kann. Hierdurch wird an der von der Saugdruck-Zuführungsplatte 11 abgewandten Flachseite der Saugplatte 10, die die Ansaugfläche 15 bildet, ein möglichst gleichmäßiger Saugdruck zur Fixierung dünner zu handhabender Platten erzeugt. Die neben den Einformungen 14 angeordneten und diese umgreifenden Kontaktflächen 16 der Saugdruck-Zuführungsplatte 11 werden dichtend mit der Saugplatte 10 verbunden, beispielsweise unter Zuhilfenahme geeigneter Klebe- oder Dichtungsmassen.

Alternativ hierzu können die Einformungen 14 prinzipiell auch an der Saugplatte 10 oder an beiden Platten 10, 11 angeordnet sein.

An einer parallel zu den Platten 10, 11 angeordneten Halteplatte 17 ist eine Vielzahl von Sauggreifern 18 fixiert, von denen in Fig. 1 vier dargestellt sind, drei in der Schnittebene und einer hinter der Schnittebene. Diese Sauggreifer 18 erstrecken sich bis in Durchbrüche 19 hinein, die durch die Saugplatte 10 und die Saugdruck-Zuführungsplatte 11 hindurch jeweils fluchtend verlaufen. Dabei sind in der in Fig. 1 dargestellten Positionierstellung am Saugende der Sauggreifer 18 angeordnete Ansaugelemente 20 innerhalb der Durchbrüche 19 angeordnet, das heißt, sie stehen nicht über die Ansaugfläche 15 der Saugplatte 10 über.

Die Sauggreifer 18 sind mittels T-Stücken an eine Saugdruckleitung 22 angeschlossen, die zur simultanen Saugdruckbeaufschlagung der Sauggreifer 18 dient. Eine entsprechende Anordnung ist auch für die pneumatischen Anschlüsse 12 erforderlich bzw. vorgesehen, jedoch zur Vereinfachung nicht dargestellt.

Die Saugdruck-Zuführungsplatte 11 und die Halteplatte 17 sind über vier Kontraktionsglieder 23, die eine pneumatische Stellgliedanordnung bilden, miteinander verbunden. Die Kontraktionsglieder 23 besitzen jeweils einen sich zwischen zwei Kopfstücken 24, 25 erstreckenden Kontraktionsschlauch 26 aus gummielastischem Material, der über einen pneumatischen Anschluss 27 innen mit einem Betätigungsfluid beaufschlagt werden kann. Die Druckbeaufschlagung bewirkt eine radiale Expansion des Kontraktionsschlauches 26, wobei eine beispielsweise in den Schlauchkörper eingebettete Strangstruktur eine axiale Kontraktion hervorruft, so dass die beiden Kopfstücke zueinander gezogen werden. Die daraus resultierende Längenveränderung des Kontraktionsgliedes 23 kann entsprechend dem eingestellten Druck des Betätigungsfluids sehr exakt vorgegeben werden.

Zur besonders präzisen Positionierung eignen sich Kontraktionsglieder 23 mit einer an den beiden Kopfstücken 24, 25 fixierten, zum Kontraktionsschlauch 26 koaxialen Strangstruktur, die zwei in Überkreuzfiguration angeordnete Stranggruppen mit innerhalb einer jeweiligen Stranggruppe mit gleicher Längsorientierung nebeneinander verlaufenden biegeflexiblen Strängen enthält. Die Stranggruppen sind dabei durch ein zwischenliegendes nachgiebiges Material, beispielsweise ein Gummimaterial oder ein Elastomermaterial auf Abstand zueinander gehalten. Durch die vermiedene unmittelbare Berührung der Stranggruppen wird die Beanspruchung des Strangmaterials beträchtlich reduziert und gleichzeitig der Wirkungsgrad verbessert. Derartige Kontraktionsglieder sind beispielsweise aus der eingangs genannten DE 299 06 626 U bekannt.

Die unteren Kopfstücke 24 der Kontraktionsglieder 23 sind dabei jeweils über Fixierglieder 28 mit der Saugdruck-Zuführungsplatte 11 und die oberen Kopfstücke 25 über Fixierglieder 29, die auch mit den pneumatischen Anschlüssen 27 versehen sind, an L-förmigen Halteelementen 30 fixiert, die sich galgenartig von der Halteplatte 17 aus nach oben erstrecken. Die Kontraktionsglieder 23 verlaufen dabei durch entsprechende Durchbrüche in der Halteplatte 17. Zur Führung der Bewegung der Halteplatte 17 einerseits und der mit der Saugplatte 10 kombinierten Saugdruck-Zuführungsplatte 11 andererseits gegeneinander und voneinander weg dient ein Führungselement 31, wobei je nach Erfordernis und Plattengröße auch mehrere Führungselemente 31 vorgesehen sein können. Dasselbe gilt für die Kontraktionsglieder 23, die im Ausführungsbeispiel mit vier angegeben ist. Auch diese Zahl kann in Abhängigkeit der Führungselemente 31 variieren.

An der Halteplatte 17 angeordnete und sich zur Saugdruck-Zuführungsplatte 11 hin erstreckende Anschlagglieder 32 begrenzen die Bewegung der Halteplatte 17 gegen die Saugdruck-Zuführungsplatte 11 derart, dass in der Anschlagposition die Ansaugelemente 20 der Sauggreifer 18 so nach unten über die Ansaugfläche 15 überstehen, dass eine zu handhabende Platte durch sie ergriffen werden kann.

Pneumatische oder elektrische Positioniermittel 33, von denen zur Vereinfachung nur die Enden von Betätigungsgliedern, beispielsweise Kolbenstangen von Pneumatikzylindern, dargestellt sind, dienen zur Bewegung und Positionierung der gesamten Anordnung. Diese Positioniermittel 33 greifen an einer Haltevorrichtung 34 an, die im Ausführungsbeispiel mit den Halteelementen 30 verbunden ist. Sie können beispielsweise auch direkt an der Halteplatte 17 oder einer damit verbundenen Vorrichtung angreifen. Durch diese Positioniermittel 33 kann die gesamte Anordnung beispielsweise in den drei Raumrichtungen positioniert werden und bei Bedarf auch geschwenkt oder gedreht werden.

In der in Fig. 1 dargestellten Positionierstellung sind die Ansaugelemente 20 der Sauggreifer 18 in die Durchbrüche 19 hineingezogen, so dass die Ansaugfläche 15 der Saugplatte 10 die unterste Ebene darstellt. Durch Saugdruckbeaufschlagung der pneumatischen Anschlüsse 12 wird eine flächige Saugwirkung durch die Saugplatte 10 bewirkt, durch die sehr dünne Platten, beispielsweise Leiterplatten, oder Folien beschädigungsfrei angezogen werden können, um sie dann anschließend zusammen mit der gesamten Anordnung mittels der Positioniermittel 33 handhaben zu können, beispielsweise zu positionieren oder von einer Arbeitsstation zur nächsten überzuführen.

Um dickere oder steifere Platten handhaben zu können, werden die pneumatischen Anschlüsse 27 der Kontraktionsglieder 23 mit Arbeitsdruck beaufschlagt, so dass sich diese zusammenziehen, bis die Saugdruck-Zuführungsplatte 11 in Kontakt mit den Anschlaggliedern 32 gelangt. Nunmehr stehen die Ansaugelemente 20 der Sauggreifer 18 nach unten über die Ansaugfläche 15 der Saugplatte 10 über, und durch Saugdruckbeaufschlagung der Saugdruckleitung 22 kann eine solche Platte an den Ansaugelementen 20 fixiert werden, um anschließend positioniert oder weiterbewegt zu werden. Das anschließende Ablegen sowohl der dickeren als auch der dünneren Platten in der gewünschten Position kann durch Druckerhöhung über den Atmosphärendruck hinaus erfolgen.

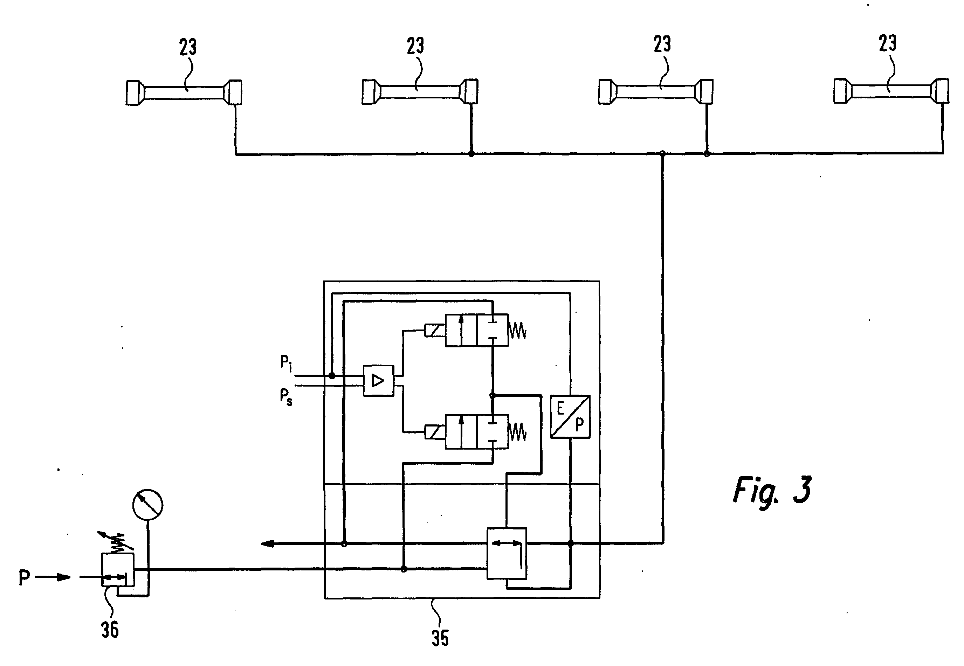

Die exakte Positionierung der Kontraktionsglieder 23 erfolgt gemäß Fig. 3 durch Druckbeaufschlagung über ein Proportional-Druckregelventil 35. Diesem ist ein Druckregler 36 vorgeschaltet. Ein derartiges Proportional-Druckregelventil 35 ist beispielsweise als Bauteil MPPES-3-1/8-10-010 der Anmelderin im Handel erhältlich. In Abhängigkeit der gewünschten Stellposition der Kontraktionsglieder 23 wird ein Solldruck Ps vorgegeben, beispielsweise über ein elektrisches Sollwert-Modul, wie es unter der Bezeichnung MPZ-1-24DC SGH-6SW im Handel erhältlich ist. Hierbei hat man die Möglichkeit, sechs analoge Sollwerte über jeweils ein integriertes Potentiometer einzustellen und durch jeweils einen zugeordneten digitalen Eingang abzurufen. Die Regelung erfolgt durch Vergleich mit dem Druck-Istwert Pi am Ausgang des Proportional-Druckregelventils 35. Durch eine derartige Anordnung lassen sich Stellpositionen im Bereich 1/10 mm exakt einstellen, wozu keine Positionsgeber an den Kontraktionsgliedern 23 erforderlich sind.

Die Kontraktionsglieder 23 eignen sich auch unabhängig von der Positionierung der Sauggreifer 28 zur Feinpositionierung der Saugplatte 10 bzw. der mit der Saugplatte 10 verbundenen Saugdruck-Zuführungsplatte 11. Hierzu müssen sich die Kontraktionsglieder 23 im zumindest teilweise kontraktierten Zustand befinden, während eine Grobpositionierung durch die Positioniermittel 33 erfolgt.

## Patentansprüche

1. Positioniereinrichtung für Gegenstände, insbesondere für pneumatische Handhabungsvorrichtungen, mit Positioniermitteln zur Positionierung in wenigstens einer Raumrichtung, wobei die Positioniermittel (33) an einer Haltevorrichtung (17, 30, 34) für den zu positionierenden Gegenstand (10, 11) angreifen, der über eine pneumatische Stellgliedanordnung (23) mit der Haltevorrichtung (17, 30, 34) verbunden ist, wobei die Stellrichtung der Stellgliedanordnung (23) der oder einer der Bewegungsrichtungen der Positioniermittel (33) entspricht, **dadurch gekennzeichnet, dass** die Stellgliedanordnung (23) zur Feinpositionierung aus wenigstens einem Kontraktionsglied besteht, das über einen sich zwischen zwei Kopfstücken (24, 25) erstreckenden und bei Innendruckbeaufschlagung eine Längenkontraktion erfahrenden Kontraktionsschlauch (26) verfügt.

2. Positioniereinrichtung nach Anspruch 1, **dadurch gekennzeichnet, dass** das wenigstens eine Kontraktionsglied der Stellgliedanordnung (23) eine zum Kontraktionsschlauch (26) koaxiale, an den beiden Kopfstücken (24, 25) fixierte Strangstruktur besitzt, die zwei in Überkreuzfiguration angeordnete Stranggruppen mit innerhalb einer jeweiligen Stranggruppe mit gleicher Längsorientierung nebeneinander verlaufenden biegeflexiblen Strängen enthält.

3. Positioniereinrichtung nach Anspruch 2, **dadurch gekennzeichnet, dass** die Stranggruppen durch ein zwischenliegendes nachgiebiges Material ständig auf Abstand zueinander gehalten werden, dass vorzugsweise als Gummimaterial oder Elastomermaterial ausgebildet ist.

4. Positioniereinrichtung nach einem der vorhergehenden Ansprüche, **dadurch gekennzeichnet, dass** die Positioniermittel (33) zur Positionierung in den drei Raumrichtungen ausgebildet sind.

5. Positioniereinrichtung nach einem der vorhergehenden Ansprüche, **dadurch gekennzeichnet, dass** die Positioniermittel (33) zum Verschwenken und/oder Rotieren ausgebildet sind.

6. Positioniereinrichtung nach einem der vorhergehenden Ansprüche, **dadurch gekennzeichnet, dass** die Positioniermittel (33) pneumatisch betätigbar sind.

7. Positioniereinrichtung nach Anspruch 6, **dadurch gekennzeichnet, dass** zur Positionierung der Stellgliedanordnung (23) ein damit verbundenes, den Innendruck der Kontraktionsglieder gemäß einem vorgebbaren Sollwert (Ps) einstellendes Proportional-Druckregelventil (35) vorgesehen ist.

8. Positioniereinrichtung nach einem der vorhergehenden Ansprüche, **dadurch gekennzeichnet, dass** der zu positionierende Gegenstand (10, 11) als pneumatische Handhabungsvorrichtung, insbesondere zur Handhabung von Platten und Folien, ausgebildet ist.

9. Positioniereinrichtung nach Anspruch 8, **dadurch gekennzeichnet, dass** die pneumatische Handhabungsvorrichtung eine Vielzahl von in einer Ebene angeordneten Sauggreifern (18) und/oder eine aus einem porösen Material oder Sintermaterial bestehende, mit einem Saugdruck beaufschlagbare Saugplatte (10) besitzt.

10. Positioniereinrichtung nach Anspruch 9, **dadurch gekennzeichnet, dass** die Saugplatte (10) mit den Durchgriff der Sauggreifer gestattenden Durchbrüchen (19) versehen ist, und dass in einer ersten Positionierstellung der Stellgliedanordnung (23) die Sauggreifer (18) über die Ansaugfläche (15) der Saugplatte (10) vorstehen und in einer zweiten Positionierstellung die Sauggreifer (18) in die Durchbrüche (19) hinein zurückversetzt sind, derart, dass sie nicht mehr über die Ansaugfläche der Saugplatte vorstehen.

11. Positioniereinrichtung nach Anspruch 10, **dadurch gekennzeichnet, dass** Steuermittel zur Beaufschlagung der Saugplatte (10) einerseits und der Sauggreifer (18) andererseits mit Saugdruck vorgesehen sind, wobei die Sauggreifer nur in der ersten Positionierstellung mit Saugdruck beaufschlagbar sind.

12. Positioniervorrichtung nach Anspruch 10 oder 11, **dadurch gekennzeichnet, dass** die Saugplatte (10) an ihrer von der Ansaugfläche (15) abgewandten Seite mit einer Saugdruck-Zuführungsplatte (11) dichtend verbunden ist, die mit wenigstens einem Saugdruck-Zuführungsanschluss (12) mit wenigstens einem flächigen Hohlraum (14) zwischen den Platten (10, 11) verbunden ist, der durch eine Einformung an wenigstens einer der Platten (11) ausgebildet ist.

13. Positioniereinrichtung nach Anspruch 12, **dadurch gekennzeichnet, dass** die Saugdruck-Zuführungsplatte (11) mit den der Saugdruckplatte (10) entsprechenden Durchbrüchen (19) für die Sauggreifer (18) versehen ist.

14. Positioniereinrichtung nach einem der vorhergehenden Ansprüche, **dadurch gekennzeichnet, dass** eine die Gegeneinanderbewegung der Platten (10, 11) in Richtung der ersten Positionsstellung begrenzende Anschlagvorrichtung (32) und/oder eine die Bewegung der Haltevorrichtung relativ zur Saugplatte (10) führende Führungseinrichtung (31) vorhanden ist.

## Claims

1. Positioning device for objects, in particular for pneumatic handling devices, with positioning means for positioning in at least one spatial direction, wherein the positioning means (33) act on a holding fixture (17, 30, 34) for the object (10, 11) to be positioned, which is connected to the holding fixture (17, 30, 34) via a pneumatic actuator assembly (23), wherein the actuating direction of the actuator assembly (23) corresponds to the direction or one of the directions of movement of the positioning means (33), **characterised in that** the actuator assembly (23) comprises at least one contraction element for fine positioning and which has a contraction tube (26) extending between two head pieces (24, 25) and undergoing a contraction in length under internal pressurisation.

2. Positioning device according to claim 1, **characterised in that** the contraction element or elements of the actuator assembly (23) has or have a strand structure coaxial to the contraction tube (26) and fixed to the two head pieces (24, 25), and containing two strand groups arranged in a crossover configuration, with flexible strands running adjacent to one another with the same longitudinal alignment within each strand group.

3. Positioning device according to claim 2, **characterised in that** the strand groups are held constantly apart by an intermediate elastic material, which is preferably rubber material or elastomer material.

4. Positioning device according to any of the preceding claims, **characterised in that** the positioning means (33) are designed for positioning in the three spatial directions.

5. Positioning device according to any of the preceding claims, **characterised in that** the positioning means (33) are designed to swivel and/or rotate.

6. Positioning device according to any of the preceding claims, **characterised in that** the positioning means (33) are pneumatically actuable.

7. Positioning device according to claim 6 **characterised in that**, to position the actuator assembly (23), there is provided a proportional pressure control valve (35) connected to the former and setting the internal pressure of the contraction elements on the basis of a presettable required value (Ps).

8. Positioning device according to any of the preceding claims, **characterised in that** the object (10, 11) to be positioned is in the form of a pneumatic handling device, in particular for the handling of panels and sheets.

9. Positioning device according to claim 8, **characterised in that** the pneumatic handling device has a multiplicity of suction grippers (18) arranged in one plane, and/or a suction plate (10) of porous material or sinter material which may be supplied with a suction pressure.

10. Positioning device according to claim 9, **characterised in that** the suction plate (10) is provided with openings (19) allowing the passage of the suction grippers, and that in a first positioning setting of the actuator assembly (23) the suction grippers (18) extend beyond the suction surface (15) of the suction plate (10), and in a second positioning setting the suction grippers (18) are recessed into the openings (19) in such a way that they no longer extend beyond the suction surface of the suction plate.

11. Positioning device according to claim 10, **characterised in that** control means are provided to supply the suction plate (10) on the one hand and the suction grippers (18) on the other hand with suction pressure, wherein the suction grippers may be supplied with suction pressure only in the first positioning setting.

12. Positioning device according to claim 10 or 11, **characterised in that** the suction plate (10) is connected with sealing, on that side of it facing away from the suction surface (15), to a suction pressure supply plate (11), which is connected to at least one suction pressure feed connection (12) with at least one flat-shaped hollow space (14) between the plates (10, 11), created by a moulding in at least one of the plates (11).

13. Positioning device according to claim 12, **characterised in that** the suction pressure supply plate (11) is provided with openings (19) for the suction grippers (18) corresponding to the suction pressure plate (10).

14. Positioning device according to any of the preceding claims, **characterised in that** there is provided a stop device (32) limiting the movement towards one another of the plates (10, 11) in the direction of the first positioning setting, and/or a guide device (31) guiding the movement of the holding fixture relative to the suction plate (10).

## Revendications

1. Dispositif de positionnement pour des objets, en particulier pour des dispositifs de manutention pneumatiques, comportant des moyens de positionnement pour le positionnement dans au moins une direction dans l'espace, lesdits moyens de positionnement (33) entrant en prise avec un dispositif de retenue (17, 30, 34) pour l'objet (10, 11) à positionner, qui est relié au dispositif de retenue (17, 30, 34) par l'intermédiaire d'un système d'actionneurs (23) pneumatique, la direction de réglage du système d'actionneurs (23) correspondant à une ou à l'une des directions de déplacement des moyens de positionnement (33), **caractérisé en ce que** le système d'actionneurs (23) pour le positionnement précis est formé par au moins un organe de contraction, qui est muni d'un tuyau de contraction (26), qui s'étend entre deux abouts (24, 25) et qui, sous l'effet d'une sollicitation de pression intérieure, subit une contraction en longueur.

2. Dispositif de positionnement selon la revendication 1, **caractérisé en ce que** ledit au moins un organe de contraction du système d'actionneurs (23) possède une structure de boyaux coaxiale au tuyau de contraction (26), laquelle est fixée aux deux abouts (24, 25) et laquelle contient deux groupes de boyaux, disposés selon une configuration en croix avec des boyaux flexibles disposés côte à côte à l'intérieur d'un groupe respectif de boyaux ayant la même orientation en longueur.

3. Dispositif de positionnement selon la revendication 2, **caractérisé en ce que** les groupes de boyaux sont maintenus en permanence à distance l'un de l'autre par l'intermédiaire d'un matériau élastique intercalé, qui est de préférence un matériau de caoutchouc ou un matériau élastomère.

4. Dispositif de positionnement selon l'une quelconque des revendications précédentes, **caractérisé en ce que** les moyens de positionnement (33) sont réalisés pour le positionnement dans les trois directions dans l'espace.

5. Dispositif de positionnement selon l'une quelconque des revendications précédentes, **caractérisé en ce que** les moyens de positionnement (33) sont réalisés pour le pivotement et/ou la rotation.

6. Dispositif de positionnement selon l'une quelconque des revendications précédentes, **caractérisé en ce que** les moyens de positionnement (33) peuvent être actionnés par voie pneumatique.

7. Dispositif de positionnement selon la revendication 6, **caractérisé en ce que**, pour le positionnement du système d'actionneurs (23), il est prévu une soupape de réglage proportionnel de la pression (35), reliée à celui-ci et réglant la pression intérieure des organes de contraction selon une valeur de consigne (Ps) prédéfinissable.

8. Dispositif de positionnement selon l'une quelconque des revendications précédentes, **caractérisé en ce que** l'objet (10, 11) à positionner est réalisé sous la forme d'un dispositif de manutention pneumatique, en particulier pour la manutention de plaques et feuilles.

9. Dispositif de positionnement selon la revendication 8, **caractérisé en ce que** la dispositif de manutention pneumatique comporte une pluralité de ventouses (18), disposées dans un plan, et/ou une plaque à succion (10), propre à être sollicitée par une pression d'aspiration, réalisée dans un matériau poreux ou un matériau fritté.

10. Dispositif de positionnement selon la revendication 9, **caractérisé en ce que** le plaque à succion (10) comporte des trous débouchants (19) permettant le passage des ventouses, et **en ce que** dans une première position de positionnement du système d'actionneurs (23), les ventouses (18) s'avancent en saillie au-delà de la surface aspirante (15) de la plaque à succion (10), et dans une deuxième position de positionnement, les ventouses (18) sont ramenées à l'intérieur des trous débouchants (19), de telle sorte qu'elles n'avancent plus au-delà de la surface aspirante du plaque à succion.

11. Dispositif de positionnement selon la revendication 10, **caractérisé en ce qu'**il est prévu des moyens de commande, destinés à solliciter la plaque à succion (10), d'une part, et les ventouses (18), d'autre part, sachant que les ventouses ne peuvent être sollicitées par la pression d'aspiration que dans la première position de positionnement.

12. Dispositif de positionnement selon la revendication 10 ou 11, **caractérisé en ce que** la plaque à succion (10), sur sa face détournée de la surface aspirante (15), est reliée de manière étanche à une plaque d'admission de la pression d'aspiration (11), laquelle est reliée à au moins un raccord d'admission de la pression d'aspiration (12) avec au moins une cavité (14) plate entre les plaques (10, 11), qui est formée par un creux ménagé dans au moins une des plaques (11).

13. Dispositif de positionnement selon la revendication 12, **caractérisé en ce que** la plaque d'admission de la pression d'aspiration (11) comporte les trous débouchants (19), correspondants à ceux de la plaque à succion (10), pour les ventouses (18).

14. Dispositif de positionnement selon l'une quelconque des revendications précédentes, **caractérisé en ce qu'**il est prévu un dispositif de butée (32), limitant le mouvement l'un contre l'autre des plaques (10, 11) dans la direction de la première position de positionnement, et/ou un dispositif de guidage (31) guidant le mouvement du dispositif de retenue par rapport à la plaque à succion (10).
